# EUROPÄISCHE PATENTSCHRIFT

(11) **EP 2 106 464 B1**
(45) Veröffentlichungstag und Bekanntmachung des Hinweises auf die Patenterteilung: **26.12.2018**
(21) Anmeldenummer: 07819686.2
(22) Anmeldetag: 08.11.2007
(51) Int. Cl.: C30B 7/00, C30B 29/60, C30B 29/40, C30B 29/46, C01B 25/08, B82Y 30/00, C01B 19/00, C09K 11/88

(54) **VERFAHREN ZUR SYNTHESE VON NANOSKALIGEN METALLHALTIGEN NANOPARTIKEL UND NANOPARTIKELDISPERSIONEN**
PROCESS FOR THE SYNTHESIS OF NANOSIZE METAL-CONTAINING NANOPARTICLES AND NANOPARTICLE DISPERSIONS
PROCÉDÉ DE SYNTHÈSE DE NANOPARTICULES À NANOÉCHELLE CONTENANT DES MÉTAUX ET DISPERSIONS DE NANOPARTICULES

(30) Priorität: 21.11.2006 DE 102006055218
(43) Veröffentlichungstag der Anmeldung: 07.10.2009
(73) Patentinhaber: Quantum Materials Corporation, San Marcos, TX 78666 (US)
(72) Erfinder: RAUSCHER, Frank, 50968 Köln (DE); HAVERKAMP, Verena, 51467 Bergisch Gladbach (DE); HENNINGER, Björn, 50677 Köln (DE); MLECZKO, Leslaw, 41542 Dormagen (DE)
(74) Vertreter: Cockerton, Bruce Roger
(86) Internationale Anmeldenummer: PCT/EP2007/009677
(87) Internationale Veröffentlichungsnummer: WO 2008/061632

(56) Entgegenhaltungen:
- EP-A- 1 452 225
- US-A1- 2004 247 517
- US-A1- 2005 016 851
- US-A1- 2005 112 849
- US-B1- 6 179 312
- NAKAMURA H; TASHIRO A; YAMAGUCHI Y; MIYAZAKI M; WATARI T; SHIMIZU H; MAEDA H: "Application of a microfluidic reaction system for CdSe nanocrystal preparation: their growth kinetics and photoluminescence analysis." LAB ON A CHIP, Bd. 4, Nr. 3, Juni 2004 (2004-06), Seiten 237-240, XP002468328 in der Anmeldung erwähnt

## Beschreibung

Die vorliegende Erfindung betrifft ein Verfahren zur Herstellung von nanoskaligen Halbleiterpartikeln (auch bekannt als Quantum Dots oder Nanokristalle) in der Flüssigphase unter Nutzung von speziell dimensionierten mikrostrukturierten Reaktionsmodulen wie Wärmetauschern, Reaktoren und Mischern.

Neben den klassischen Einsatzgebieten von funktionellen nanoskaligen Partikeln z.B. in der Katalyse oder als Pigmente stehen heute zunehmend High-Tech-Anwendungen in der Biotechnologie, der Medizin, der Sicherheitstechnologie, der Computer-, Elektro- und Energietechnik sowie der Optik im Fokus. Darüber hinaus bestehen vielfältige Einsatz- und Verwendungsmöglichkeiten in den Materialwissenschaften, da funktionelle Nanopartikel Kompositmaterialien zu völlig neuen Eigenschaften verhelfen können. Für die jeweiligen speziellen Anwendungen ist die Kontrolle der Produkteigenschaften u.a. die Partikelmorphologie, die Partikelgröße, die Partikelgrößenverteilung, die kolloidale Stabilität der Dispersionen sowie die Verarbeitungseigenschaften der Partikel entscheidend. Gerade bei Halbleiter-Nanopartikeln variieren die physikalisch-chemischen Eigenschaften sehr stark mit der Partikelgröße, der Partikelmorphologie und der Breite der Partikelgrößenverteilung. Damit kommt der kontrollierten Synthese, die ein gezieltes Einstellen der Partikeleigenschaften erlaubt, ein besonders hoher Stellenwert zu (T. Trintade et al., Chem. Mater., 2001, 13, 3843-3858; C. Burda et al., Chem. Rev., 2005, 105, 1025-1102).

Nanoskalige Halbleiterpartikel können mittels Gasphasensynthesen hergestellt werden, diese eignen sich allerdings aufgrund des apparativen Aufwands und der Komplexität der vorgeschlagenen Verfahren kaum für die Herstellung größerer Mengen.

Eine weitere Möglichkeit zur Herstellung besteht in der Flüssigphasen-Synthese von nanoskaligen Halbleiterpartikeln. Diese Flüssigphasen-Verfahren, die entweder Wasser (hydrothermal) oder organische Lösungsmittel (solvothermal) nutzen, können sowohl diskontinuierlich als auch kontinuierlich durchgeführt werden.

Die diskontinuierlichen Verfahren sind am ausführlichsten untersucht worden. Bei diesen Verfahren wird entweder von einer oder mehreren Precursorlösungen, die dann zu vermischen sind, ausgegangen. Unterschiede bestehen unter anderem in der Art des eingesetzten Lösungsmittels, der verwendeten Tenside, der eingesetzten Precursor und der Dosierungs- und Reaktionstemperaturen.

C. B. Murray et al. beschreibt erstmals ein diskontinuierliches, solvothermales Verfahren zur Herstellung von nahezu monodispers verteilten Halbleiter-Nanopartikeln (C. B. Murray et al., J. Am. Chem. Soc., 1993, 115, 8706-8715). Dabei dient eine reine Tensidlösung als Reaktionsmedium für die Synthese. Ein Precursor wird in Lösung unter inerter Atmosphäre in einem thermostatisierten Rührkesselreaktor vorgelegt und auf die gewünschte Temperatur gebracht. Die zweite Precursorlösung wird dann möglichst schnell, unter intensivem Rühren und bei gleichzeitigem Absenken der Temperatur, der ersten Precursorlösung zugesetzt ("Hot-Injection" Methode).

C. de Mello et al. gibt einen Überblick über die üblichen Prozessbedingungen und die verwendeten Lösungsmittel und Tenside für diese "Hot-Injection" Methode zur Synthese von Halbleiter-Nanopartikeln (C. de Mello et al., Small, 2005, 1, 1152-1162).

Die Herstellung von Halbleiter-Nanopartikeln erfolgt im diskontinuierlichen Verfahren (Batch-Verfahren) üblicherweise unter Verwendung eines koordinierend wirkenden Lösungsmittels (z.B. Trioctylphosphinoxid TOPO), um den Partikelbildungsprozess unter kontrollierten Bedingungen ablaufen zu lassen. Nach der Zudosierung einer zweiten Precursorlösung zu einer auf Temperatur gebrachten ersten Precursorlösung ("Hot-Injection" Methode), lässt man das Reaktionsgemisch bis auf eine bestimmte Temperatur abkühlen, sodass der Wachstumsprozess nicht parallel zum Keimbildungsprozess stattfindet (siehe dazu z.B. WO2001007689 A2, US6872249).

US6576291 beschreibt die Mischung zweier Precursorlösungen unter Verwendung geeigneter Tenside (z.B. Trioctylphosphin TOP) bei Raumtemperatur und die anschließende, schnelle Zugabe dieser Mischung in eine reine Tensid/Lösungsmittelmischung die auf eine Temperatur von 360 °C gebracht wurde. Auch hier wird nach dem Dosierungsschritt die Temperatur für das kontrollierte und langsame Wachstum der Halbleiter-Nanopartikel auf 275 °C abgesenkt.

WO1997010175 beschreibt außerdem die Bildung eines organischen Precursors aus den für die Partikelbildung notwendigen Komponenten durch eine Komproportionierungsreaktion (Liganden Metathese). Nach der Einmischung dieses Precursors in eine Tensid/Lösungsmittelmischung wird der gesamte Reaktorinhalt möglichst schnell auf die für die Partikelbildung notwendige Temperatur von 250 °C gebracht und auf dieser Temperatur über 30 Minuten gehalten.

Diskontinuierliche Verfahren eignen sich auch für die Synthese von sogenannten Kern-Schale Nanopartikeln (Core/Shell Nanopartikel), wobei die Synthese der Kern-Nanopartikel zuerst nach bereits beschriebenen Methoden erfolgt. Anschließend wird in einem zweiten Schritt die entsprechende Precursorlösung für den Aufbau der Schale bei Temperaturen von ca. 220 °C zugegeben (siehe dazu z.B. US6207229, US6815064).

US6225198 beschreibt, dass die Precursorkonzentration, die Reaktionstemperatur und die spezifischen Eigenschaften der eingesetzten Tenside und der Precursorlösung im diskontinuierlichen Verfahren auch die Form der Nanopartikel beeinflussen kann, sodass neben 0D- auch 1D-, 2D- und 3D-Strukturen synthetisiert werden können.

Entscheidend für die kontrollierte Bildung der Halbleiter-Nanopartikeln sind unter anderem ein möglichst homogenes Temperaturfeld im Reaktor, eine stabile Reaktionstemperatur, die Möglichkeit einer sehr schnellen Wärmezu- und abfuhr und im Falle einer Zudosierung einer zweiten Precursorlösung eine effiziente Vermischung. Bei diskontinuierlichen Verfahren lassen die Güte der Temperaturkontrolle und der Vermischung aber mit zunehmendem Gesamtreaktionsvolumen stark nach, sodass diese Verfahren üblicherweise nur die Synthese geringer Mengen dieser Halbleiter-Nanopartikel (1-50 ml Ansätze) erlauben. Für die Herstellung größerer Mengen müssen somit unter beträchtlichem Arbeitsaufwand diskontinuierliche Synthesen parallel oder nacheinander durchgeführt werden. Schwankungen der Prozessparameter bei der Durchführung der einzelnen Synthesen führen dann zwangsläufig zu einem Qualitätsverlust.

Um möglichst monodispers verteilte Nanopartikel herzustellen, ist es zweckmäßig den sogenannten Keimbildungsprozess zeitlich vom nachfolgenden Wachstumsprozess zu entkoppeln (J. de Mello et al., Lab Chip, 2004, 4, 11N-15N).

Darüber hinaus könnte eine örtliche Trennung zwischen Keimbildungs- und Wachstumsprozess eine präzise Einstellung der idealen jeweiligen Prozessparameter und somit eine optimale Steuerung der Partikeleigenschaften ermöglichen. Eine örtliche Trennung ist aber bei diskontinuierlichen Verfahren nicht möglich. Eine kontinuierlich durchgeführte Synthese, die sowohl eine zeitliche als auch eine örtliche Trennung der Keimbildungs- und Wachstumsprozesse ermöglicht, ist bisher nicht bekannt, obwohl sie inhärente Vorteile gegenüber der etablierten diskontinuierlichen Fahrweise (Batch-Synthese) bieten könnte.

Außerdem stellt die Tatsache, dass die üblicherweise verwendeten Tenside und Lösungsmittel einen erheblichen Teil der Synthesekosten ausmachen, ein weiteres Hemmnis bei der Herstellung größerer Mengen dieser Halbleiter-Nanopartikel dar.

In WO2005052996 wird die Verwendung von preiswerten Wärmeträgerölen (z.B. Dowtherm A) als Reaktionsmedium für die diskontinuierliche Synthese beschrieben. Neben den bis dato teilweise verwendeten nicht-koordinierenden Lösungsmitteln wie Octadecen, kann so noch mal eine deutliche Kostenabsenkung erzielt werden.

Erste Versuche kontinuierlich betriebene Reaktoren für die Synthese von Halbleiter-Nanopartikeln zu nutzen, führten zur Verwendung von dünnen Kapillaren die in ein Ölbad getaucht und auf die benötigten Temperaturen aufgeheizt wurden. Die Precursorlösungen werden dabei unter Verwendung von koordinierenden Lösungsmitteln vorgemischt und bei leicht erhöhten Temperaturen, der auf bis zu 330 °C temperierten Kapillare, zugeführt (H. Nakamura et al., Lab Chip, 2004, 4, 237-240). Durch die Verwendung einer einheitlich temperierten Kapillare lassen sich jedoch Keimbildung und Wachstum nicht ausreichend zeitlich und örtlich voneinander trennen.

Auch verschiedene andere funktionelle Nanopartikel konnten in Kapillarreaktoren kontinuierlich dargestellt werden. In allen Fällen dient die Kapillare der Temperierung der Reaktionslösung um die Reaktion und die anschließende Partikelbildung zu initiieren.

In EP1452225 A1 ist die Synthese von Gold-, Cadmiumsulfid- und Cadmiumselenid-Nanopartikeln beschrieben.

Patent US6179912 beschreibt ein kontinuierliches Verfahren zur Herstellung von verschiedenen Halbleiter-Nanopartikeln, dass unter Verwendung koordinierend wirkender Lösungsmittel (TOPO) mehrere Mischstrecken nutzt, um die Precursorlösung vor der Zuführung in den kontinuierlich, bei stark erhöhten Temperaturen, betriebenen Reaktor zu vermischen. Dabei müssen auch schon die Vorlagebehälter und die Mischstrecken beheizt werden, da das verwendete Lösungsmittel bei Raumtemperatur als wachsartiger Feststoff vorliegt.

Ähnlich der Vorgehensweise bei der diskontinuierlichen Synthese lässt sich auch für die kontinuierliche Betriebsweise eine Dosierung der beiden Precursor in eine zuvor auf die entsprechende Temperatur gebrachte Tensidlösung (TOPO) realisieren (M. Kawa et al., J. Nanopart. Res., 2003, 5, 81-85).

US5652192 beschreibt ein kontinuierliches Verfahren zur Synthese von nanoskaligen Partikeln in wässriger Phase unter Nutzung eines temperierten und unter Druck (hydrothermal) gesetzten, kontinuierlich betriebenen Reaktors.
US2005/0112849 A1 beschreibt ein kontinuierliches Flüssigphasen-Verfahren zur Herstellung von metallhaltigen Nanopartikeldispersion, dadurch gekennzeichnet, dass eine Regelung der Temperatur und Volumenströme stattfindet.
US2004/0247517 A1 beschreibt ein Verfahren zur Herstellung von Nanopartikeln, indem vorgemischte Precursorlösung in ein Reaktionsrohr kontunuierlich eingeführt wird, wobei ein Wärmeübertragungsmedium die Reaktionsmischung auf die gewünschte Reaktionstemperatur bringt.

Die Kombination von Mischer, Aufheiz- und Verweilzeitstrecke in einem Bauteil zur Synthese nanoskaliger Partikel wird in WO2005020659 beschrieben. Die Verwendung mehrerer Zudosierungsstellen erlaubt so auch die Beschichtung von Nanopartikeln (Herstellung von Kern-Schale Partikeln).

Um die evidenten Nachteile der Kapillarverfahren, wie ungenügende Trennung von Keimbildungs- und Wachstumsphase, extrem niedrige Volumenströme, ungenügende Vermischung der Eduktströme, breite Verweilzeitverteilungen aufgrund des laminaren Strömungsprofils sowie die daraus resultierende breite Partikelgrößenverteilungen auszugleichen, werden auch sogenannte "Segmented-Flow" Konzepte zur Synthese von funktionellen Nanopartikeln eingesetzt (B.K.H. Yen et al., Angew. Chem. Int. Ed., 2005, 44, 5447-5451). Dabei wird ein segmentierendes Fluid (Gas oder nichtmischbare Flüssigkeit) eingesetzt, um in einem kontinuierlich durchströmten Reaktor diskrete Reaktionsvolumen, die einer Eigenzirkulation unterliegen, zu erzeugen.

In WO1998002237 wird allgemein die Durchführung von Fällungsreaktionen zur Synthese von Feststoffpartikeln in einem segmentiert durchströmten Rohrreaktor beschrieben. Die Vermischung der beiden Reaktanden kann dabei zeitgleich mit der Segmentierung erfolgen oder ist dieser vorgeschaltet.

Die Nutzung von segmentiert durchströmten Reaktoren liefert, im Vergleich zur Durchführung der Reaktion im Kapillarreaktor, Nanopartikel mit einer deutlich engeren Partikelgrößenverteilung. Allerdings nimmt auch hier die Qualität der Nanopartikel bez. Größenverteilung deutlich ab, wenn höhere Volumenströme (ml/min) durchgesetzt und somit größere Mengen an Nanopartikeln produziert werden sollen. Des Weiteren steigt der Komplexitätsgrad des Verfahrens, da die Dosierung des Segmentierungsfluids sehr präzise und gleichmäßig erfolgen muss. Dies ist bei höheren Volumenströmen nahezu unmöglich.

Alternative Verfahren, die zur kostengünstigen Flüssigphasen-Synthese größerer Mengen an nanoskaligen Halbleiterpartikeln mit gezielt einstellbarer Partikelgröße und Partikelgrößenverteilung geeignet sind, werden daher gebraucht. Dies bezieht sich insbesondere auf Verfahren, mit denen man konzentrierte und kolloidal-stabile (d.h. mit höheren Standzeiten insbesondere von einigen Stunden bis hin zu mehreren Tagen) Partikeldispersionen reproduzierbar und im industriellen Maßstab herstellen kann und die die genannten Nachteile der etablierten Verfahren nicht aufweisen.

Die Aufgabe der vorliegenden Erfindung bestand daher darin, ein kontinuierliches Verfahren zur Herstellung von nanoskaligen Halbleiterpartikeln bzw. anderen metallhaltigen funktionellen Nanopartikeln und/oder deren Dispersion bereitzustellen, welches Laufzeiten im Bereich von Stunden und insbesondere im Bereich von Tagen ermöglicht. Außerdem soll dieses Verfahren die genannten Produkte in gewünschter Qualität, d.h. mit gezielt einstellbarer mittlerer Partikelgröße, einer nahezu monodispersen Partikelgrößenverteilung und einer gewünschten Partikelmorphologie in größeren Mengen und insbesondere im Bereich von g/h und mehr liefern.

Die Aufgabe wird durch das vorliegende erfindungsgemäße Verfahren in einer kontinuierlich durchströmten Reaktionsstrecke, bestehende aus mehreren geeigneten Reaktionsmodulen, gelöst, wobei eine zeitliche und örtliche Trennung der Keimbildungs- und Wachstumsprozesse durch die Verwendung von vorzugsweise mikrostrukturierten Reaktionsmodulen mit separater Regelung der Temperatur erreicht wird.

Vorzugsweise wird das Verfahren in einem Reaktor durchgeführt der, z. B. durch Einbau von statischen Mischern, eine gute radiale und eine geringe axiale Vermischung erlaubt und somit das Einstellen einer engen Verweilzeitverteilung ermöglicht. Das erfindungsgemäße Flüssigphasen-Verfahren wird in einer Mikroreaktionstechnikanlage durchgeführt, die im Vergleich zu konventioneller Reaktionstechnik eine sehr präzise Regelung und Kontrolle von Temperatur und Mischbedingungen gestattet.

Im Rahmen der vorliegenden Erfindung wird unter einer Mikroreaktionstechnikanlage eine modulare aufgebaute Anlage aus mehreren Mikroreaktionstechnikkomponenten verstanden. Üblicherweise besteht eine Mikroreaktionstechnikanlage aus mindestens einem mikrostrukturierten Reaktor. Das erfindungsgemäße Flüssigphasen-Verfahren wird kontinuierlich betrieben.

Überraschenderweise wurde gefunden, dass bei der Verwendung von geeigneten organischen Lösungsmitteln durch das o.g. Verfahren in einer modularen Mikroreaktionstechnikanlage metallhaltige Nanopartikel insbesondere Halbleiter-Nanopartikel mit gewünschter Partikelgröße, Partikelgrößenverteilung und Partikelmorphologie kontinuierlich hergestellt werden können. Überraschenderweise wurde auch festgestellt, dass bei Verwendung geeigneter Lösungsmittel die entsprechenden Precursor bei Raumtemperatur oder leicht erhöhter Temperatur (insbesondere ≤ 100 °C) vorgemischt und somit bis in den molekularen Bereich durchmischt in einem Strang durch die auf die Reaktionstemperatur aufgeheizte Mikroreaktionstechnikanlage geführt werden können. Unter Strang, Reaktionsstrang bzw. Reaktionsstrecke wird im Rahmen des erfindungsgemäßen Verfahrens eine sequentielle Reihenschaltung von Reaktionsmodulen verstanden.

Die Temperatur bei der Vorvermischung der Precursor wird vorzugsweise so gewählt, dass chemische Reaktion und Keimbildung nicht in signifikantem Maße im Vorlagebehälter und in den Förderleitungen stattfinden können. Dies kann z. B. durch Überwachung der Farbe oder Eintrübung der Precursorlösung im Vorlagebehälter festgestellt werden. Darüber hinaus wurde gefunden, dass die extrem hohen Wärmeübertragungsraten in Mikroreaktionstechnikkomponenten in Kombination mit temperierbaren mikrostrukturierten Verweilzeitreaktoren mit statischen Mischeinbauten eine zeitliche und örtliche Trennung der Keimbildungs- und Wachstumsprozesse ermöglichen, die zu bestimmten Partikelgrößen bzw. Partikelmorphologien und engen Partikelgrößenverteilungen der Halbleiter-Nanopartikel führt. Die Steuerung der zeitlich und örtlich getrennten Keimbildungs- und Wachstumsprozesse ermöglicht dann eine gezielte Einstellung der Partikelgröße, der Partikelgrößenverteilung und der Partikelmorphologie, sodass 0D-, 1D-, 2D- und 3D-Strukturen selektiv synthetisiert werden können, wobei 0D-Strukturen kugelförmige Nanoteilchen, 1D-Strukturen z. B. Stäbchen, 2D-Strukturen z. B. Plättchen und 3D-Strukturen z. B. Tetrapoden oder verzweigte Nanostrukturen sind.

Insbesondere wurde festgestellt, dass der Wachstumsprozess und damit der Aufbau von komplexen Strukturen (2D bzw. 3D) durch die eingesetzten Tenside, die absoluten Konzentrationen der Reaktanden und Tenside, durch die molaren Verhältnisse der jeweiligen Reaktanden zueinander sowie durch die genaue Kontrolle der Temperatur bei der Keimbildung und während der Wachstumsphase insbesondere mit Hilfe geeigneter Verhältnisse von Wärmeübertragungsfläche zu Reaktionsvolumen (A/V-Verhältnisse) gesteuert werden kann.

Gegenstand der Erfindung ist daher ein kontinuierlich geführtes Verfahren zur Herstellung, insbesondere von morphologisch einheitlichen und nahezu monodispers verteilten, metallhaltigen Nanopartikeln und/oder Nanopartikeldispersionen, dadurch gekennzeichnet, dass durch eine separate Regelung der Temperatur und der Volumenströme eine zeitlich und örtlich Trennung der Keimbildungs- und Wachstumsprozesse erreicht wird, wobei die Reaktion und Partikelbildung vorzugsweise in einem geeigneten mikrostrukturierten, modularen Reaktorsystem (Mikroreaktionstechnikanlage) initiiert und durchgeführt wird. Die Modularisierung der Mikroreaktionstechnikanlage (Mikrowärmetauscher, Mikroreaktor, Mikromischer etc.) erlaubt eine optimale Einstellung der jeweiligen chemischen und verfahrenstechnischen Prozessparameter und somit die Herstellung von nahezu monodispers verteilten und morphologisch einheitlichen Nanopartikeln.

Gleichzeitig erlaubt das erfindungsgemäße Verfahren die kontinuierliche Herstellung von größeren Mengen dieser Nanopartikel (im Bereich g/h - kg/h).

Bevorzugt können mit dem erfindungsgemäßen Verfahren nanoskalige Partikel mit einer charakteristischen mittleren Partikelgröße von bis zu 40 nm, in einer bevorzugten Ausführung von 0,5 bis 20 nm und in einer ganz besonders bevorzugten Ausführung Partikel mit charakteristischen Abmessungen von 1 bis 10 nm hergestellt werden, wobei unter charakteristischer Abmessung die eigenschaftsbestimmende Abmessung, z.B. der Stäbchendurchmesser oder der Armdurchmesser bei Tetrapoden verstanden wird.

Üblicherweise kann eine Partikelgrößenverteilung mit einer Standardabweichung von ± 10 nm, bevorzugt von ± 5 nm und besonders bevorzugt von ± 2 nm erreicht werden. Eine Partikelgrößenverteilung kann beispielsweise durch eine statistische Analyse von Transmissionselektronenmikroskopaufnahmen erstellt und ausgewertet werden.

Das erfindungsgemäße Verfahren ermöglicht weiterhin die Einstellung von Partikeleigenschaften kugelförmiger und insbesondere nicht-kugelförmiger Partikel wie z. B. Stäbchen, Plättchen oder Tetrapoden. Insbesondere erlaubt das erfindungsgemäße Verfahren die Einstellung einer Eigenschaftsverteilung mit einer Standardabweichung von ± 20 %, bevorzugt von ± 10 % und insbesondere von ± 5 %. Eine interessierende Eigenschaft kann z.B. das UV-Vis Absorptionsmaxima, der Brechungsindex oder die Schmelztemperatur sein.

Die Nanopartikel werden in der Flüssigphase unter Zuhilfenahme von Tensiden synthetisiert. Die Partikeloberfläche ist während des Partikelbildungsprozesses und auch nach dessen Abschluss permanent mit einer Tensidschicht bedeckt. Neben der stabilisierenden Wirkung erlaubt die Tensidschicht darüber hinaus die problemlose Abtrennung und Redispergierung der Nanopartikel in den meisten organischen Lösungsmitteln (z.B. Toluol, Cyclohexan, Tetrahydrofuran, Chloroform, Methylenchlorid), um eine weitere Verarbeitung bzw. Handhabung zu ermöglichen oder um kolloidal-stabile Partikeldispersionen herzustellen.

Weiterhin lässt das erfindungsgemäße Verfahren aufgrund der kontinuierlichen Betriebsweise eine einfache Überführung von einem Labor- auf den Produktionsmaßstab zu, bei gleichzeitiger Beibehaltung der im Labor erreichten Produktqualität.

Bevorzugt ermöglicht das Verfahren die Synthese von Nanopartikeln, insbesondere funktionellen Nanopartikeln wie z.B. Metalloxide oder kolloidale Edelmetalle und besonders bevorzugt die Synthese von Halbleiter-Nanopartikeln (z.B. II-VI bzw. III-V-Verbindungshalbleiter).

Besonders bevorzugt ermöglicht das Verfahren die kontinuierliche Synthese von Halbleiter-Nanopartikeln (z.B. II-VI bzw. III-V-Verbindungshalbleiter) verschiedener Form (kugelförmige Partikel, Stäbchen, Plättchen, Tetrapoden, Kern-Schale oder dotierte Nanopartikel) und Größe in einem geeignetem organischen Reaktionsmedium.

Bei dem vorliegenden Verfahren werden als Reaktanden üblicherweise metallische Edukte wie z.B. Cd, Zn, In, Pb, Ga, Cu, Sn, Mn, Fe, Ti, deren Metalloxide oder Salze (Edukt 1), sowie Se-, Te-, As-, S-, P-, O-haltige Verbindungen (Edukt 2) eingesetzt. Die Edukte werden in dem erfindungsgemäßen Verfahren in gelöster Form (Precursorlösungen) verwendet.

Im Sinne des voliegenden erfindungsgemäßen Verfahrens wird unter Precursorlösung eine homogene Mischung bestehend aus Edukt, Tensid bzw. Tensidmischung und organischem Reaktionmedium verstanden.

Zur Herstellung der Precursorlösungen werden Tenside benötigt.

Als Tenside und zur Bildung der entsprechenden Precursorlösung 1 des metallischen Edukts (Edukt 1) eignen sich besonders langkettige Fettsäuren, z.B. Ölsäure, Linolsäure, Stearinsäure, Palmitinsäure, Tetradecansäure, Undecansäure etc.

Als Tenside und zur Bildung der entsprechenden Precursorlösung 2 des weiteren Edukts (Edukt 2) eignen sich insbesondere:
∘ lineare oder verzweigte Alkylphosphane z.B. Tri-Butylphosphan, Tri-Hexylphosphan, TriOctylphosphan, Tri-(tert-butyl)phosphan, Tris-(trimethylsilyl)phosphan,
∘ Tri-Octylphosphanoxid sowie Phosphon- und Carbonsäuren z.B. Tetradecylphosphonsäure, Octadecylphosphonsäure,
∘ Quaternäre Ammoniumverbindungen und Amine z.B. Cetyltrimethylammoniumbromid
∘ Alkylethercarboxylate und Salze der Fettamine
∘ mit koordinierenden Gruppen funktionalisierte Oligothiophene sowie
∘ unsymetrisch substituierte Perylene mit koordinierend wirkenden Gruppen.

Bei dem erfindungsgemäßen Verfahren werden Reaktionsmedien bevorzugt, die das Mischen der Precursorlösungen bei Raumtemperatur, bzw. einer Temperatur bei der Reaktion und Keimbildung nicht in signifikantem Maße ablaufen, zulassen, einen möglichst hohen Siedepunkt von mindestens 270 °C haben und die bei Temperaturen von bis zu 350 °C keine Zersetzungserscheinungen aufweisen.

Bevorzugt werden Reaktionsmedien, die sowohl die Edukte (Precursor) als auch die Tenside vollständig lösen.

Geeignet als Reaktionsmedium sind insbesondere aber nicht ausschließlich organische Lösungsmittel mit hohem Siedepunkt wie z.B.:
∘ Tri-Octylphosphanoxid (TOPO),
∘ Octadecen (ODE),
∘ Siliconöle,
∘ Alkylaromaten,
∘ Alkylphenylether,
∘ teilhydrierte Bi-, Ter- und Polyphenyle bzw. Mischungen daraus,
∘ sowie andere Wärmeträgeröle (z.B. Diphyl THT, Diphyl DT oder Therminol 66).

Durch Verwendung eines geeigneten Lösungsmittels können die entsprechenden Precursorlösungen bei leicht erhöhten Temperaturen maximal aber bis 150 °C, bevorzugt bis 120 °C und besonders bevorzugt bis 100 °C als eine homogene Mischung vorgelegt und in einem Strang durch die Reaktionsapparatur gefördert werden. Chemische Reaktion und Keimbildung finden dabei erst in den entsprechend auf Temperatur gebrachten Stufen der Reaktionsapparatur statt und nicht in den temperierten Vorlagebehältern.

Alternativ kann die Mischung der Precursor auch durch Verwendung von Mischern mit mikrostrukturierten internen Mischstrukturen (z.B. Mikromischer) erfolgen, die ein effizientes und schnelles Vermischen erlauben.

Das Verfahren ermöglicht durch gezielte Variation der chemischen und verfahrenstechnischen Parameter (Tenside, Konzentrationen, molaren Konzentrationsverhältnisse, Temperaturen, Volumenströme etc.) die genaue Einstellung der Partikelgröße, der Partikelgrößenverteilung und der Partikelmorphologie.

Die chemischen Parameter betreffen dabei vor allem die Zusammensetzung der Precursorlösungen, d.h. die Auswahl der eingesetzten Tenside sowie die Festlegung der Konzentrationen und der molaren Konzentrationsverhältnisse der Edukte und Tenside zueinander.

In einer ersten Ausführungsform des erfindungsgemäßen Verfahrens erfolgt die Synthese ausgehend von einer bzgl. Temperatur und Konzentration vollständig homogenisierten Mischung beider Precursorlösungen, die bei Temperaturen unterhalb von 100 °C keine signifikanten Reaktionen und insbesondere keine Keimbildung erkennen lässt.

Erfindungsgemäß wird als Precursorlösung 1 bevorzugt eine Lösung aus Edukt 1 mindestens einem metallhaltigen Edukt, Lösungsmittel und mindestens einem Tensid 1 (bevorzugt langkettige Fettsäuren) eingesetzt. Als Precursorlösung 2 wird bevorzugt eine Lösung aus Se-, Te-, As-, S-, P-, O-haltigen Verbindungen, Lösungsmittel und mindestens einem Tensid 2 (bevorzugt ein Tri-Alkylphosphan oder ein funktionalisiertes Oligothiophen) eingesetzt.

Die Tenside werden zweckmäßigerweise mit einer Konzentration zwischen 0,1 M und 2 M, bevorzugt zwischen 0,2 M und 1,25 M und insbesondere zwischen 0,4 M und 1,0 M in den Precursorlösungen verwendet.

Die metallhaltigen Edukte in Precursorlösung 1 werden zweckmäßigerweise mit einer Konzentration zwischen 0,001 M und 2 M, bevorzugt zwischen 0,01 M und 1,0 M und insbesondere zwischen 0,01 M und 0,5 M eingesetzt.

In Precursorlösung 2 werden zweckmäßigerweise Se-, Te-, As-, S-, P-, O-haltige Verbindungen mit einer Konzentration zwischen 0,001 M und 2 M, bevorzugt zwischen 0,01 M und 1,0 M und insbesondere zwischen 0,01 M und 0,5 M eingesetzt.

Bevorzugt werden frisch angesetzte Precursorlösungen eingesetzt.

Zweckmäßigerweise liegt das molare Einsatzverhältnis von metallhaltigem Edukt zu der entsprechenden Se-, Te-, As-, S-, P-, O-haltige Verbindung in den Precursormischungen zwischen 0,5 und 10,0, bevorzugt zwischen 0,7 und 5,0 und insbesondere zwischen 0,9 und 2,0.

Das die Reaktivität der Precursorlösung bestimmende Einsatzverhältnis von Edukt 1 oder 2 und dem entsprechenden Tensid liegt zweckmäßigerweise in den jeweiligen Precursormischungen zwischen 0,01 und 1 bevorzugt zwischen 0,05 und 0,8 und insbesondere zwischen 0,06 und 0,5.

In einer weiteren Ausführungsform des Verfahrens erfolgt die Zudosierung von Precursorlösungen entlang des Reaktionsstrangs bzw. der Reaktionsstrecke.

Die Zudosierung entlang des Reaktionsstrangs von Precursorlösung 1 wird zweckmäßigerweise mit einer Konzentration des metallhaltigen Edukts in der Precursorlösung zwischen 0,001 M und 2 M, bevorzugt zwischen 0,01 M und 1 M und insbesondere zwischen 0,01 M und 0,5 M durchgeführt.

Zur Zudosierung entlang des Reaktionsstrangs von Precursorlösung 2 werden zweckmäßigerweise Se-, Te-, As-, S-, P-, O-haltige Verbindungen mit einer Konzentration in der Precursorlösung zwischen 0,001 M und 2 M, bevorzugt zwischen 0,01 M und 1 M und insbesondere zwischen 0,01 M und 0,5 M eingesetzt.

Die Konzentrationen beider Precursorlösungen müssen bei der Zudosierung so gewählt werden, dass es nicht zu erneuter Keimbildung bzw. zur Bildung neuer Partikel im Reaktor kommt.

Bevorzugt werden frisch angesetzte Precursorlösungen eingesetzt.

Zweckmäßigerweise liegt bei der Zudosierung das molare Einsatzverhältnis von metallhaltigem Edukt zu der entsprechenden Se-, Te-, As-, S-, P-, O-haltigen Verbindung in der Precursormischung zwischen 0,5 und 10,0, bevorzugt zwischen 0,7 und 5,0 und insbesondere zwischen 0,9 und 2,0.

Das die Reaktivität der Precursorlösung bei der Zudosierung bestimmende Einsatzverhältnis von Edukt 1 oder 2 und dem entsprechenden Tensid liegt zweckmäßigerweise in den jeweiligen Precursormischungen zwischen 0,01 und 1, bevorzugt zwischen 0,05 und 0,8 und insbesondere zwischen 0,06 und 0,5.

Ggf. können den Precursorlösungen weitere lösliche Substanzen wie z.B. niedrig-molekulare Additive, Salze und Tenside zugesetzt werden.

Beim dem erfindungsgemäßen Verfahren kann die Nanopartikelsynthese und somit die Partikeleigenschaft auch durch Einstellung und Variation der verfahrenstechnischen Parameter wie Versuchstemperaturen (Aufheizrate, Temperatur der Verweilstrecke, Abkühlrate etc.), Volumenströme bzw. Verweilzeiten und über die Mischungsbedingungen gesteuert werden. Zusätzliche Zudosierungsstellen entlang des Reaktionsstrangs bzw. der Reaktionsstrecke erlauben außerdem vorzugsweise die gezielte Einstellung und Kontrolle der Precursorkonzentrationen im Mikroreaktor sowie in nachgeschalteten Reaktionsstufen.

Das erfindungsgemäße Verfahren eignet sich sowohl für mischungs- als auch temperaturinitiierte Partikelsynthesen, da die Nutzung von geeigneten Mikroreaktionstechnikkomponenten sowohl bei Stoff- als auch bei Wärmeübertragungsvorgängen deutlich höhere Werte erlaubt (W. Ehrfeld et al., Microreactors, Wiley-VCH, 2000), als in Batch- bzw. Kapillarreaktoren unter Idealbedingungen erzielbar sind. Des Weiteren kann über die Verwendung von Mikromischern entlang des Reaktionstrangs bzw. der Reaktionsstrecke die kontrollierte Zudosierung einer weiteren Precursorlösung (kann mit der Ausgangsprecursorlösung identisch sein) erfolgen, um gezielt Form und Größe der Nanopartikel einzustellen (z.B. die Synthese verzweigter Nanostrukturen) oder Nanopartikel mit einer anorganischen Hülle (Kern-Schale Nanopartikel) zu beschichten bzw. um gewünschte Dotierungen vorzunehmen.

Bei der diskontinuierlichen als auch bei der kontinuierlichen Synthese von Halbleiter-Nanopartikeln über sogenannte solvothermale Verfahren, muss zur Initiierung der Partikelbildungsreaktion Wärme zugeführt werden.

Zur Temperierung kann die Kapillare oder der Mikroreaktor in ein Ölbad eingesetzte werden, um so die notwendige Temperaturerhöhung zu realisieren. Auch die Nutzung von Mikrowellentechnik kann zum schnellen Aufheizen der Reaktionslösung dienen. Bevorzugt werden jedoch Mikrowärmetauscher bzw. in Mikroreaktoren integrierte Wärmetauscher verwendet, die für eine deutlich verbesserte und kontrollierte Wärmeübertragung und somit für eine schnellere und effizientere Aufheizung der Reaktionslösung sorgen. Kontinuierliche Verfahren mit solchen Temperier- bzw. Mischeinheiten haben gegenüber Batch- bzw. Kapillarverfahren den Vorteil, dass die Hochskalierung der Produktion vom Labor- auf den Produktionsmaßstab durch das "numbering up" Prinzip (anstatt "scaling up") stark vereinfacht wird. Die Hochskalierung kann deswegen, im Vergleich zum Labor, bei gleichbleibender Produktqualität erfolgen. Außerdem ermöglichen die verwendeten Mikroreaktionstechnikmodule das Einstellen von unterschiedlichen Temperaturniveaus entlang des Reaktionsstrangs bzw. der Reaktionsstrecke und somit die zeitliche und örtliche Trennung von Keimbildung und Wachstum.

Besonders bevorzugt werden Mikrowärmetauscher bzw. Mikroreaktoren mit integrierter statischer Mischfunktion verwendet, in welchen die Partikelbildungsreaktion unter definierten Strömungsbedingungen, wie geringe axiale und gute radiale Vermischung und der daraus resultierenden engen Verweilzeitverteilung, im kontinuierlichen Betrieb durchgeführt werden kann (z.B. der Sandwich-Reaktor von Ehrfeld Mikrotechnik BTS GmbH).

Die verwendete Bezeichnung "Mikroreaktor" steht dabei stellvertretend für mikrostrukturierte, vorzugsweise kontinuierlich arbeitende Reaktoren, die unter der Bezeichnung Mikroreaktor, Minireaktor, Mikrowärmetauscher, Minimischer oder Mikromischer bekannt sind. Beispiele hierfür sind Mikroreaktoren, Mikrowärmetauscher, T- und Y-Mischer sowie Mikromischer verschiedenster Firmen (z.B. Ehrfeld Mikrotechnik BTS GmbH, Institut für Mikrotechnik Mainz GmbH, Siemens AG, CPC-Cellulare Process Chemistry Systems GmbH), wobei unter "Mikroreaktor" bzw. "mikrostruktuiert" im Sinne der vorliegenden Erfindung üblicherweise Bauteile mit charakteristischen/bestimmenden geometrischen Abmessungen von 1 µm - 2000 µm und besonders bevorzugt von 10 µm-1000 µm verstanden werden.

Gegenstand der vorliegenden Erfindung ist ein Flüssigphasen-Verfahren zur Herstellung von Nanopartikeln und/oder Nanopartikeldispersionen in einer Mikroreaktionstechnikanlage durch folgende Schritte gekennzeichnet:
a) Injektion bzw. Förderung einer vorgemischten Precursorlösung, die mindestens ein Edukt (1 und/oder 2) und mindestens ein Tensid (1 und/oder 2) beinhaltet in bzw. durch eine Mikroreaktionstechnikanlage mit durchgesetzten Volumenströme vorzugsweise von 0,05 ml/min bis 500 ml/min, bevorzugt 0,5 ml/min bis 250 ml/min und insbesondere von 1,0 ml/min bis 100 ml/min.
b) Gegebenenfalls Injektion bzw. Förderung einer weiteren Precursorlösung die mindestens ein weiteres Edukt (1 und/oder 2) und mindestens ein Tensid (1 und/oder 2) beinhaltet, und Vermischung der beiden Precursorlösungen a) und b) über ein geeignetes Mischelement (z.B. Mikromischer) zu einer Reaktionslösung.
c) Initiierung von chemischer Reaktion und insbesondere Keimbildung durch schnelles Aufheizen der aus mindestens 2 Precursorlösungen bestehenden Reaktionslösung auf eine Temperatur bei der Reaktion und Keimbildung in signifikantem Maße stattfinden, vorzugsweise von mehr als 200 °C, bevorzugt sind Temperaturen von 250 °C bis 400 °C und insbesondere von 260 °C bis 350 °C.
d) Kontrolliertes Wachstum der Nanopartikel durch Temperieren/Heizen der Reaktionslösung in einem Verweilzeitreaktor auf eine Temperatur von mehr als 150 °C, bevorzugt liegt die Temperatur zwischen 180 °C und 280 °C und insbesondere zwischen 220 °C und 280 °C, wobei die Temperatur niedriger als die benötigte Temperatur für die Keimbildung sein muss.

In einer besonderen Ausführungsform des Verfahrens wird in einem weiteren Schritt
e) das Partikelwachstum durch möglichst abrupte Abkühlung der Reaktionslösung (Quenching) gestoppt, wobei die Abkühlungstemperatur deutlich niedriger als die Temperatur für die Keimbildung und die Wachstumstemperatur ist und 150 °C nicht übersteigen sollte.

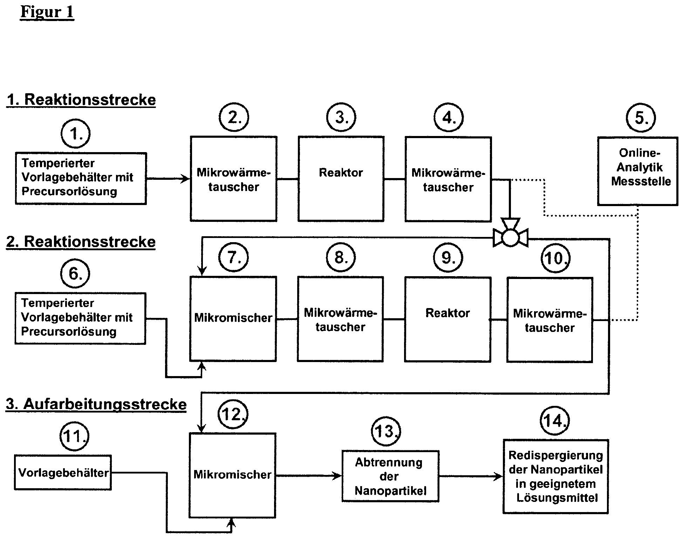

Bevorzugt wird das erfindungsgemäße Verfahren zur Herstellung der nanoskaligen funktionellen Partikel in einem vollständig aus Mikroreaktionstechnikkomponenten bestehenden, modularen System, wie z.B. in Fig. 1 dargestellt, ohne sich darauf zu begrenzen, durchgeführt. Dieses System besteht bevorzugt aus mindestens einem temperierbaren und mit Inertgas gespülten Vorlagebehälter (1), einem Mikrowärmetauscher (2), einem temperierbaren mikrostrukturierten Verweilzeitreaktor mit statischen Mischeinbauten (3), einem weiteren Mikrowärmetauscher (4) zur schnellen Abkühlung der Reaktionslösung und gegebenenfalls einer On-line Analytikmessstelle (5).

Besonders bevorzugt wird dabei die aus mindestens einer Precursorlösung bestehende Reaktionslösung über Pumpen oder Hochdruckpumpen, bspw. HPLC-Pumpen, mit konstanter Flussrate und sehr geringer Pulsation durch die modulare aufgebaute Mikroreaktionstechnikapparatur bzw. durch eine Apparatur aus mikrostrukturierten Bauteilen gepumpt. Besonders bevorzugt folgt dem ersten Reaktionsstrang bzw. der Reaktionsstrecke zur Durchführung der Reaktionschritte a) bis e) eine zweite Reaktionsstrecke, die die Zudosierung frischer Precursorlösung aus einem weiteren mit Inertgas gespülten und temperierbaren Vorlagebehälter (6) zu der aus der ersten Reaktionsstrecke austretenden Reaktionslösung erlaubt. Die Vermischung beider Volumenströme erfolgt bevorzugt in einem mikrostrukturierten Mischer (7), der eine schnelle und effiziente Vermischung ermöglicht. Die mit frischer Precursorlösung angereicherte Reaktionslösung wird dann durch einen weiteren Mikrowärmetauscher (8), einen temperierbaren mikrostrukturierten Reaktor mit statischen Mischeinbauten (9) und einen Mikrowärmetauscher (10) zur schnellen Abkühlung der Reaktionslösung gefördert. Auch der zweite Reaktionsstrang kann durch eine On-line Analytikmessstelle überwacht werden.

Der modularisierte Aufbau bietet im Gegensatz zu komplett integrierten Reaktorsystemen (siehe WO2005020659) den Vorteil der optimalen Entkopplung und damit der präzisen Kontrolle der einzelnen Prozessstufen und somit eine noch bessere Möglichkeit die Partikeleigenschaften gezielt zu kontrollieren und einzustellen.

Zur Durchführung im kontinuierlichen Betrieb werden bestimmte verfahrenstechnische Parameter wie z.B. die Auswahl des Mikroreaktors bzw. die Abfolge der Module festgelegt, andere, wie z.B. Temperatur, Volumenströme und Konzentrationen (über Zudosierung) entlang der Reaktionsstrecke, können während der Durchführung des erfindungsgemäßen Verfahrens gezielt variiert und eingestellt werden. So werden z.B. auch die mittleren Verweilzeiten in der Anlage über die Regelung der Volumenströme kontrolliert.

Die Flussraten bzw. die Volumenströme der Reaktionslösung entlang eines Reaktionsstrangs bzw. einer Reaktionsstrecke liegen zweckmäßigerweise in Bereichen von 0,05 ml/min bis 500 ml/min, bevorzugt von 0,5 ml/min bis 250 ml/min und insbesondere von 1,0 ml/min bis 100 ml/min.

Die eingesetzten Mikrowärmetauscher haben dabei zweckmäßigerweise ein Verhältnis von Wärmeübertragungsfläche zu Reaktionsvolumen (A/V Verhältnis) von mindestens 20.000 m²/m³, bevorzugt von mindestens 25.000 m²/m³ und insbesondere von mindestens 30.000 m²/m³.

Die eingesetzten Mikrowärmetauscher zum Aufheizen der Reaktionslösung ermöglichen Temperaturen von mehr als 200 °C, bevorzugt Temperaturen von 250 °C bis 400 °C und insbesondere von 260 °C bis 350 °C.

In einer besonderen Ausführungsform des Verfahrens findet Schritt c) in dem Mikrowärmetauscher (2) statt und die Temperaturerhöhung im Schritt c) wird vorzugsweise mit Hilfe eines Verhältnisses von Wärmeübertragungsfläche zu Reaktionsvolumen (A/V-Verhältnis) von mindestens 20.000 m²/m³ erreicht.

Die Verweilzeiten im eingesetzten Mikrowärmetauscher (2) liegen zweckmäßigerweise in einem Bereich von 0,036 s bis 360 s, bevorzugt von 0,072 s bis 36 s und insbesondere von 0,18 s bis 18 s. Dies entspricht einer Flussrate/einem Volumenstrom der Reaktionslösung von 0,05 ml/min bis 500 ml/min, bevorzugt 0,5 ml/min bis 250 ml/min und insbesondere von 1,0 ml/min bis 100 ml/min.

Insbesondere kann während des Keimbildungs- und Wachstumsprozesses die Morphologie der Nanopartikel durch die eingesetzten Tenside, die Konzentrationen der Reaktanden und Tenside und die molaren Einsatzverhältnisse der jeweiligen Reaktionskomponenten (Edukte und Tenside) zueinander sowie durch die Kontrolle der Temperatur und der Volumenströme gesteuert werden.

In einer besonderen Ausführungsform des Verfahrens wird die Keimbildung (Schritt c)) und das Partikelwachstum (Schritt d)) durch eine abrupte Abkühlung (Quenching) der Reaktionslösung gestoppt. Bevorzugt wird für die Reaktionslösung so eine Temperatur von weniger als 150 °C, besonders bevorzugt eine Temperatur von 0 bis 100 °C und insbesondere von 0 bis 50 °C eingestellt.

In einer besonderen Ausführungsform des Verfahrens findet Schritt d) in temperierbaren mikrostrukturierten Reaktoren mit statischen Mischeinbauten (3) statt. Als temperierbare mikrostrukturierte Reaktoren mit statischen Mischeinbauten (3) werden zweckmäßigerweise kontinuierlich betriebene Reaktoren mit einem Verhältnis von Wärmeübertragungsfläche zu Reaktionsvolumen (A/V-Verhältnis) von mindestens 800 m²/m³, bevorzugt 1000 m²/m³ und insbesondere mit einem Verhältnis von mindestens 1200 m²/m³ eingesetzt. Die eingestellte Temperatur für das kontrollierte Wachstum beträgt üblicherweise mehr als 150 °C, bevorzugt liegt sie zwischen 180 °C und 280 °C und insbesondere zwischen 220 °C und 280 °C. Die Temperatur im Reaktor (3) ist dabei vorzugsweise kleiner gleich der Temperatur im Schritt c) (Keimbildung) und wird vorzugsweise mit Hilfe eines A/V-Verhältnisses von mindestens 1000 m²/m³ erreicht.

Die statischen Mischeinbauten sorgen dabei aufgrund der geringen axialen und guten radialen Durchmischung für eine optimale Wärmeübertragung und eine enge Verweilzeitverteilung. Die mittleren Verweilzeiten in den eingesetzten Reaktoren liegen zweckmäßigerweise zwischen 10 s und 300 s, bevorzugt zwischen 60 s und 600 s und insbesondere zwischen 90 s und 1200 s. Dies entspricht einer Flussrate/einem Volumenstrom der Reaktionslösung von 0,05 ml/min bis 500 ml/min, bevorzugt 0,5 ml/min bis 250 ml/min und insbesondere von 1,0 ml/min bis 100 ml/min.

Dadurch, dass die Verweilzeitverteilung in den eingesetzten mikrostrukturierten Reaktoren (3) durch die statischen Mischeinbauten deutlich schmaler ist als in einem Rohr oder einer Kapillare, wird so besonders die Synthese von Nanopartikeln mit einer engen Partikelgrößenverteilung ermöglicht. Der Reaktor (3) dient vorzugsweise dem gleichmäßigen und definierten Wachstum der in der Stufe c) gebildeten Nanopartikelkeime hin zu Nanopartikeln der gewünschten Größe. Die Größe kann dabei sowohl über die chemischen Parameter und/oder vorzugsweise über die Temperatur und die Volumenströme kontrolliert werden.

In einer besonderen Ausführungsform des Verfahrens wird die schnelle Temperaturabsenkung im Schritt e) vorzugsweise mit Hilfe eines nachgeschalteten Mikrowärmetauschers (4) mit einem A/V-Verhältnis von mindestens 20.000 m²/m³ erreicht.

Vorzugsweise werden in der bereits beschriebenen ersten Reaktionsstrecke Nanopartikel mit einer maximalen charakteristischen Abmessung (z.B. Durchmesser bei runden Nanopartikeln) von 10 nm produziert. Zur kontrollierten Herstellung von monodispers verteilten größeren Nanopartikeln, verzweigten Nanostrukturen, dotierten Nanopartikeln oder Kern-Schale-Strukturen ist es vorteilhaft, die gebildeten Nanopartikeln aus der ersten Reaktionsstrecke über folgende Schritte weiterzubehandeln/zu modifizieren:
f) Injektion mindestens einer frischen Precursorlösungen über ein geeignetes Mischelement (z.B. Mikromischer).
g) Wiederholung der Schritte d) und e).

Die zweite Reaktionsstrecke wird bevorzugt zur Herstellung von Kern-Schale Nanopartikeln (sogenannten "Core-Shell Particle"), dotierten Nanopartikeln, Nanostäbchen ("Nanorods"), Nanoplättchen, Nanotetrapoden oder mehrfach verzweigten Nanostrukturen genutzt, da sie die separate Einstellung und Kontrolle idealer Reaktionsbedingungen (Temperatur, Verweilzeit, Konzentration etc.) ermöglicht. Die Nutzung einer zweiten Reaktionsstrecke (der ersten Strecke nachgeschaltet) erlaubt auch die Herstellung von größeren aber monodispers verteilten kugelförmigen Nanopartikeln.

Sind die Precursorlösungen im Schritt f) identisch mit den Precursorlösungen der Schritte a) und b), so können größere oder verzweigte Nanostrukturen (z.B Nanostäbchen oder Nanotetrapoden) synthetisiert werden.

Sind die Precursorlösungen im Schritt f) nicht identisch mit den Precursorlösungen aus den Schritten a) und b), können Kern-Hülle-Strukturen bzw. dotierte Nanopartitkel gebildet werden.

Des Weiteren können in diesem Fall auch mehrfach verzweigte Nanostrukturen aus verschiedenen Materialien hergestellt werden.

Vorzugsweise weist die zweite Reaktionsstrecke einen Mikromischer zur Durchführung von Schritt f), einen mikrostrukturierten Wärmetauscher und einen temperierbaren mikrostrukturierten Reaktor mit statischen Mischeinbauten sowie einen nachgeschalteten Wärmetauscher auf, deren Eigenschaften equivalent sind zu den Eigenschaften der Mikroreaktionstechnikkomponenten aus der ersten Reaktionsstrecke.

In einer weiteren Ausführungsform des Verfahrens folgt der zweiten Reaktionsstrecke eine Aufarbeitungsstrecke. Ein geeignetes Lösungsmittel (Fällungsmittel oder Antisolvent) zur temporären reversiblen Ausfällung der Nanopartikel wird aus einem Vorlagebehälter (11) gefördert und bevorzugt in einem mikrostrukturierten Mischer (12), der eine schnelle und effiziente Vermischung ermöglicht, mit der aus einer der beiden Reaktionsstrecken austretenden Reaktionslösung vermischt. In einer weiteren Stufe (13) kann dann die Abtrennung der nanoskaligen Partikel erfolgen.

Die in der zweiten Reaktionsstrecke und in der Aufarbeitungsstrecke verwendeten Mikromischer haben zweckmäßigerweise eine Mischzeit kleiner als 10 s, bevorzugt kleiner als 5 s, und insbesondere kleiner als 0,5 s. Die Mischzeit beschreibt dabei die Zeitspanne die benötigt wird, um die Reaktionslösung zu homogenisieren.

Ebenfalls Gegenstand dieser Erfindung ist daher ein vorzugsweise kontinuierlich betriebenes Verfahren, dadurch gekennzeichnet, dass sowohl die Synthese von von funktionellen metallischen Nanopartikeln oder Halbleiter-Nanopartikeln (erste Reaktionsstrecke) als auch deren weitere Modifikation zu Kern-Schale Nanoteilchen, dotierten Nanopartikeln, Nanostäbchen, Nanoplättchen Nanotetrapods und mehrfach verzweigten Nanostrukturen (zweite Reaktionsstrecke mit Zudosierung), sowie die Aufarbeitung der synthetisierten Nanostrukturen (Aufarbeitungsstrecke) in einer modular aufgebauten Mikroreaktionstechnikanlage integriert werden.

Zur Abtrennung von gelösten Begleitstoffen wie überschüssigen Tensiden und nicht umgesetzten Precursoren und zur Aufkonzentrierung der Nanopartikeldispersion können auch die üblicherweise gängigen Verfahren wie z.B. Ultrafiltration, Membranfiltration, Dialyse und Zentrifugation genutzt werden. Außerdem erlaubt die Verwendung eines geeigneten Lösungsmittels (Fällungsmittel oder Antisolvent), zur gezielten Einleitung der reversiblen Aggregation und Sedimentation der Nanopartikel, die Abtrennung aus der Reaktionslösung.

In einer weiteren optimierten Ausführungsform des Verfahrens können diese Trennungsverfahren kontinuierlich betrieben werden und sich der bereits integrierten Aufarbeitungsstrecke anschließen.

Nach dem erfindungsgemäßen Verfahren kann die Nanopartikeldispersion mittels Standardverfahren (z.B. Ultrafiltration, Membranfiltration, Dialyse, Zentrifugation und Eindampfen) aufkonzentriert und ggf. gereinigt werden.

Durch einen Waschschritt oder durch den Zusatz von Additiven können ggf. die kolloid-chemische Stabilität und die anwendungstechnischen Eigenschaften der Nanopartikeldispersion optimiert bzw. gezielt variiert werden.

Zur Herstellung der Nanopartikeldispersion können schließlich in einem weiteren Schritt des erfindungsgemäßen Verfahrens die Nanopartikel in einem geeigneten Lösungsmittel (z.B. Touluol, Chloroform, Dichlormethan, Chlorbenzol oder Butylacetat) redispergiert werden.

Zur Charakterisierung der Nanopartikel wurden die Partikelgröße, die Partikelgrößenverteilung, und die Partikelmorphologie mittels Transmissionselektronenmikroskopie (TEM, Philips CM 20) bestimmt. Außerdem eignen sich Messverfahren wie die dynamische Lichtstreuung (hydrodynamische Partikelgröße, Brookhaven BIC-90 Plus) und die UV/VIS-Spektroskopie (Hewlett Packard Diode Array Spectrophotometer 8452A), um nanoskalige Partikel zu charakterisieren.

Das Verfahren kann zur kontinuierlichen Herstellung von nanoskaligen metallhaltigen Partikeln und Halbleiterpartikeln und deren Dispersionen bzw. Formulierungen z.B. für Katalysatoren, Beschichtungsmaterialien, dünne funktionelle Schichten, Materialien für die Elektronik, Materialien mit bestimmten optischen Eigenschaften, Solarzellen, Biolabel, Herstellung von halbleitenden bzw. leitenden Nano- und Mikrostrukturen, Materialien für Anti-Fälschungsmethoden, zur Einfärbung von Kunststoffen und für Kunststoffkomposite mit speziellen Eigenschaften verwendet werden.

### Figuren

Fig. 1: Schematische Darstellung des Verfahrens
   Figur 1 zeigt eine schematische Darstellung der Vorrichtung zur Durchführung der kontinuierlichen Synthese von funktionellen Nanopartikeln, ohne sich darauf zu begrenzen.
   Bezugzeichen:
   1. Reaktionsstrecke
      1- Temperierter Vorlagebehälter für Precursorlösungen (Lösungsmittel, Tenside, Precursor)
      2- Mikrowärmetauscher (sprunghafte Temperaturerhöhung)
      3- Temperierter, mikrostrukturierter Reaktor mit statischen Mischeinbauten
      4- Mikrowärmetauscher (sprunghafte Temperaturerniedrigung)
      5- Online-Analytik
   2. Reaktionsstrecke
      6- Temperierter Vorlagebehälter für Precursorlösungen (Lösungsmittel, Tenside, Precursor)
      7- Mikromischer
      8- Mikrowärmetauscher (sprunghafte Temperaturerhöhung)
      9- Temperierter, mikrostrukturierter Verweilzeitreaktor mit statischen Mischeinbauten
      10- Mikrowärmetauscher (sprunghafte Temperaturerniedrigung)
   3. Aufarbeitungsstrecke
      11- Vorlagebehälter (Fällungsmittel oder Antisolvent)
      12- Mikromischer
      13- Abscheider (Abtrennung der aggregierten Nanopartikel)
      14- Redispergierung der Nanopartikel in einem geeigneten Lösungsmittel
Fig. 2: TEM-Aufnahme von Cadmiumselenid (CdSe) Nanopartikeln hergestellt nach Beispiel 1.
Fig. 3: TEM-Aufnahme von verzweigten Cadmiumselenid (CdSe) Nanopartikeln hergestellt nach Beispiel 2.
Fig. 4: TEM-Aufnahme von Indiumphosphid (InP) Nanopartikeln hergestellt nach Beispiel 3.
Fig. 5: TEM-Aufnahme von verzweigten Cadmiumtellurid (CdTe) Nanopartikeln hergestellt nach Beispiel 4.
Fig. 6: TEM-Aufnahme von Zinkselenid (ZnSe) Nanopartikeln hergestellt nach Beispiel 5.
Fig. 7: UV/VIS Spektrum der CdSe Nanopartikel in Toluol bei zwei unterschiedlichen Volumenströmen hergestellt nach Beispiel 1. Dabei zeigt die gestrichelte Linie das Spektrum der Nanopartikel, die bei einem Volumenstrom von 4,6 ml/min bzw. bei einer Verweilzeit τ von 6,5 min hergestellt wurden, während die duchgezogene Linie das Spektrum der Nanopartikel zeigt, die bei einem Volumenstrom von 9,9 ml/min bzw. bei einer Verweilzeit τ von 3 min hergestellt wurden. Die Versuchstemperaturen betrugen hier 260°C im Mikrowärmetauscher und 260°C im Verweilzeitreaktor.
Fig. 8: UV/VIS Spektrum der InP Nanopartikel in Toluol bei zwei unterschiedlichen Volumenströmen hergestellt nach Beispiel 3. Dabei zeigt die gestrichelte Linie das Spektrum der Nanopartikel, die bei einem Volumenstrom von 4,6 ml/min bzw. bei einer Verweilzeit τ von 6,5 min hergestellt wurden, während die duchgezogene Linie das Spektrum der Nanopartikel zeigt, die bei einem Volumenstrom von 9,9 ml/min bzw. bei einer Verweilzeit τ von 3 min hergestellt wurden. Die Versuchstemperaturen betrugen hier 300°C im Mikrowärmetauscher und 270°C im Verweilzeitreaktor.

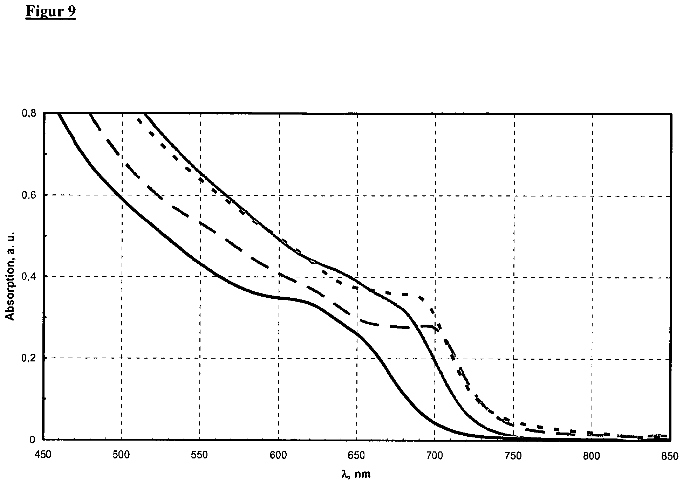

Fig. 9: UV/VIS Spektrum der verzweigten CdTe Nanopartikel in Toluol bei zwei unterschiedlichen Volumenströmen und Temperaturen hergestellt nach Beispiel 4 . Dabei zeigt die kurzgestrichelte schwarze Linie das Spektrum der Nanopartikel, die bei einem Volumenstrom von 9,9 ml/min bzw. bei einer Verweilzeit τ von 3 min hergestellt wurden, während die graue langgestrichelte Linie das Spektrum der Nanopartikel zeigt, die bei einem Volumenstrom von 4,6 ml/min bzw. bei einer Verweilzeit τ von 6,5 min hergestellt wurden. Die Versuchstemperaturen betrugen hier 300°C im Mikrowärmetauscher und 230°C im Verweilzeitreaktor.

Die durchgezogene schwarze Linie zeigt das Spektrum der Nanopartikel, die bei einem Volumenstrom von 9,9 ml/min bzw. bei einer Verweilzeit τ von 3 min hergestellt wurden, während die graue durchgezogene Linie das Spektrum der Nanopartikel zeigt, die bei einem Volumenstrom von 4,6 ml/min bzw. bei einer Verweilzeit τ von 6,5 min hergestellt wurden. Die Versuchstemperaturen betrugen hier 270°C im Mikrowärmetauscher und 200°C im Verweilzeitreaktor.

Die nachfolgenden Beispiele sollen die vorliegende Erfindung illustrieren ohne sie jedoch einzuschränken.

### Beispiele:

### Beispiel 1: Herstellung von CdSe Nanopartikeln

Es wurde eine 0,5 molare Selen Lösung (Lösungsmittel Trioctylphosphan) hergestellt (39,5 g Selen/l TOP). Für die zweite Precursorlösung wurden 0,03 Mol Cadmiumoxid (CdO) pro Liter Ölsäure/Diphyl THT (Gewichtsverhältnis1/5) Gemisch gelöst. Zur vollständigen Lösung des CdO muss die zweite Precursorlösung auf mindestens 220 °C erwärmt werden. Nach dem Abkühlen der CdO Precursorlösung konnten beide Precursorlösungen im Gewichtsverhältnis 1/10 in einem Vorlagebehälter bei Raumtemperatur oder leicht erhöhter Temperatur vermischt werden. Mit einem Gesamtvolumenstrom von 10 ml/min wurde die Reaktionslösung, bestehend aus beiden zuvor vermischten Precursorlösungen, dann unter Verwendung einer HPLC Doppelkolbenpumpe durch die modulare aufgebaute Mikroreaktionstechnikanlage (Ehrfeld Mikrotechnik BTS GmbH) geführt.

Das Temperiermedium am ersten Mikrowärmetauscher (Gegenstrom Mikrowärmetauscher, V ≈ 0,3 ml, A ≈ 0,0076 m², Ehrfeld Mikrotechnik BTS GmbH) hatte dabei eine Temperatur von 330 °C, während das Temperiermedium für den mikrostrukturierten Reaktor (Sandwichreaktor, V ≈ 30 ml, A ≈ 0,03 m², Ehrfeld Mikrotechnik BTS GmbH) eine Temperatur von 260 °C hatte.

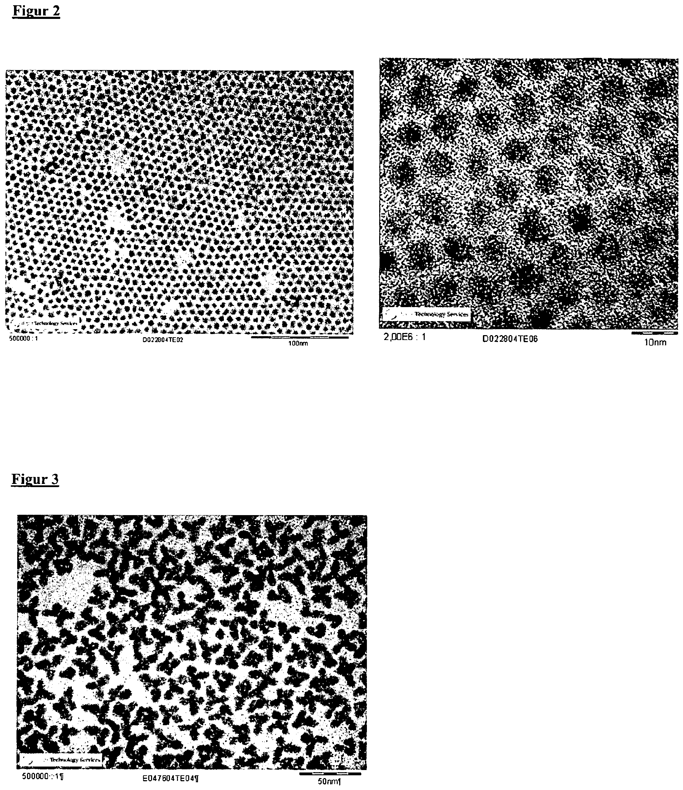

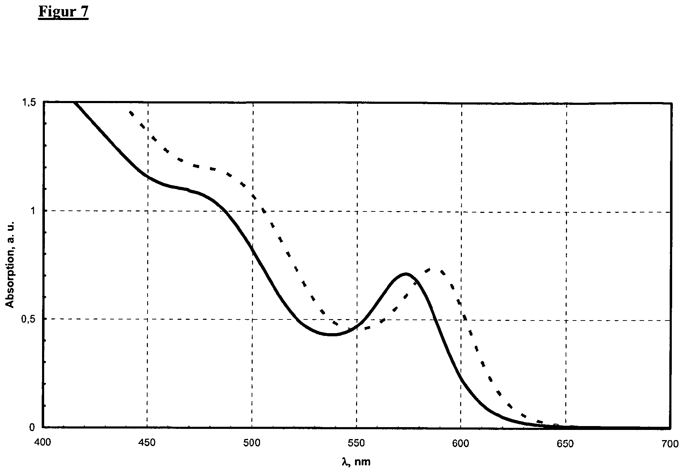

Mithilfe des zweiten Mikrowärmetauschers (Gegenstrom Mikrowärmetauscher oder Rohrtemperiermodul, Ehrfeld Mikrotechnik BTS GmbH) wurde die Reaktionslösung mit den gebildeten Nanopartikeln (erkennbar an der Einfärbung der Reaktionslösung) auf 50 °C abgekühlt und in einem Produktbehälter aufgefangen. Die Abtrennung der Nanopartikel erfolgte durch Zugabe eines Lösungsmittels (Fällunsmittel/Antisolvent, z.B. Methanol/Propanol Gemisch), welches die reversible Aggregation der Nanopartikel einleitet. Nach der Abtrennung des Überstandes erfolgte eine Redispergierung in Toluol, Chloroform oder einem anderen geeigneten Lösungsmittel. Anschließend kann eine wie auch immer geartet Charakterisierung der Nanoteilchen erfolgen (TEM und UV/VIS - Analyse siehe Figur 2 und 7).

### Beispiel 2: Herstellung von verzweigten CdSe Nanopartikeln

Es wurde eine 0,3 molare Selen Lösung (Lösungsmittel Trioctylphosphan) hergestellt (25 g Selen/l TOP). Zu dieser Lösung wurde eine zweite Tensidlösung bestehend aus Cetyltrimethylammoniumbromid (CTAB) und Diphyl THT gegeben (13 g CTAB/l Diphyl THT).

Beide Lösungen formen im Gewichtsverhältnis 1/1 die erste Precursorlösung. Für die zweite Precursorlösung wurden 0,07 Mol Cadmiumoxid (CdO) pro Liter Ölsäure/Diphyl THT (Gewichtsverhältnis1/4) Gemisch gelöst. Zur vollständigen Lösung des CdO muss die zweite Precursorlösung auf mindestens 220 °C erwärmt werden. Nach dem Abkühlen der CdO Precursorlösung konnten beide Precursorlösungen im Gewichtsverhältnis 1/3 in einem Vorlagebehälter bei Raumtemperatur oder leicht erhöhter Temperatur vermischt werden. Mit einem Gesamtvolumenstrom von 10 ml/min wurde die Reaktionslösung, bestehend aus beiden zuvor vermischten Precursorlösungen, dann unter Verwendung einer HPLC Doppelkolbenpumpe durch die modulare aufgebaute Mikroreaktionstechnikanlage (Ehrfeld Mikrotechnik BTS GmbH) geführt.

Das Temperiermedium am ersten Mikrowärmetauscher (Gegenstrom Mikrowärmetauscher, V ≈ 0,3 ml, A ≈ 0,0076 m², Ehrfeld Mikrotechnik BTS GmbH) hatte dabei eine Temperatur von 330 °C, während das Temperiermedium für den mikrostrukturierten Reaktor (Sandwichreaktor, V ≈ 30 ml, A ≈ 0,03 m², Ehrfeld Mikrotechnik BTS GmbH) eine Temperatur von 280 °C hatte.

Mithilfe des zweiten Mikrowärmetauschers (Gegenstrom Mikrowärmetauscher oder Rohrtemperiermodul, Ehrfeld Mikrotechnik BTS GmbH) wurde die Reaktionslösung mit den gebildeten Nanopartikeln (erkennbar an der Einfärbung der Reaktionslösung) auf 50 °C abgekühlt und in einem Produktbehälter aufgefangen. Die Abtrennung der Nanopartikel erfolgte durch Zugabe eines Lösungsmittels (Fällunsmittel/Antisolvent, z.B. Methanol/Propanol Gemisch), welches die reversible Aggregation der Nanopartikel einleitet. Nach der Abtrennung des Überstandes erfolgte eine Redispergierung in Toluol, Chloroform oder einem anderen geeigneten Lösungsmittel. Anschließend kann eine wie auch immer geartet Charakterisierung der Nanoteilchen erfolgen (TEM - Analyse siehe Figur 3).

### Beispiel 3: Herstellung von InP Nanoteilchen

Es wurde eine 0,04 molare Tris(trimethylsilyl)phosphane (P(TMS)₃) Lösung (Lösungsmittel Diphyl THT) hergestellt (10 g P(TMS)₃/l Diphyl THT). Für die zweite Precursorlösung wurden 0,03 Mol Indiumacetat (In(Ac)₃) pro Liter Ölsäure/Diphyl THT (Gewichtsverhältnis 1/30) Gemisch gelöst. Zur vollständigen Lösung des In(Ac)₃ muss die zweite Precursorlösung auf mindestens 120 °C erwärmt werden. Nach dem Abkühlen der In(Ac)₃ Precursorlösung konnten beide Precursorlösungen im Gewichtsverhältnis 1/2 in einem Vorlagebehälter bei Raumtemperatur oder leicht erhöhter Temperatur vermischt werden. Mit einem Gesamtvolumenstrom von 10 ml/min wurde die Reaktionslösung, bestehend aus beiden zuvor vermischten Precursorlösungen, dann unter Verwendung einer HPLC Doppelkolbenpumpe durch die modulare aufgebaute Mikroreaktionstechnikanlage (Ehrfeld Mikrotechnik BTS GmbH) geführt.

Das Temperiermedium am ersten Mikrowärmetauscher (Gegenstrom Mikrowärmetauscher, V ≈ 0,3 ml, A ≈ 0,0076 m², Ehrfeld Mikrotechnik BTS GmbH) hatte dabei eine Temperatur von 300 °C, während das Temperiermedium für den mikrostrukturierten Reaktor (Sandwichreaktor, V ≈ 30 ml, A ≈ 0,03 m², Ehrfeld Mikrotechnik BTS GmbH) eine Temperatur von 270 °C hatte.

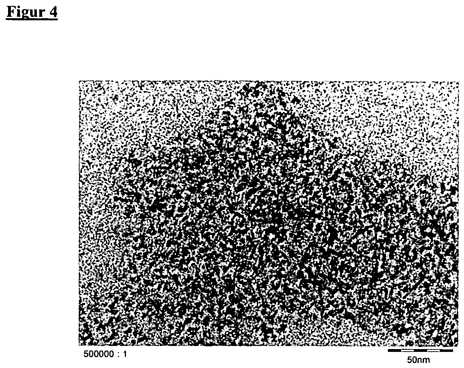

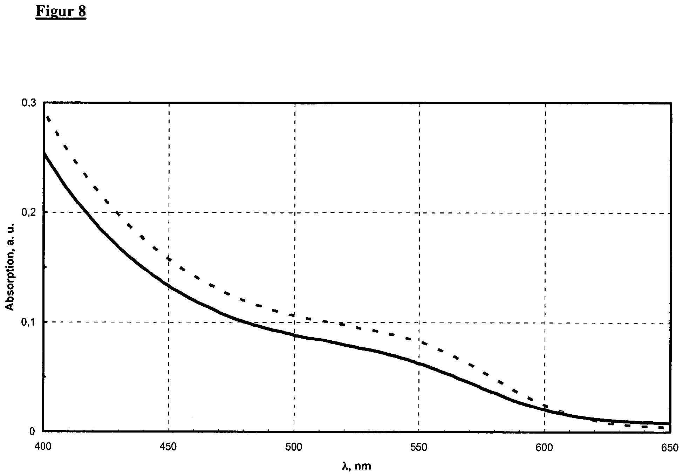

Mithilfe des zweiten Mikrowärmetauschers (Gegenstrom Mikrowärmetauscher oder Rohrtemperiermodul, Ehrfeld Mikrotechnik BTS GmbH) wurde die Reaktionslösung mit den gebildeten Nanopartikeln (erkennbar an der Einfärbung der Reaktionslösung) auf 50 °C abgekühlt und in einem Produktbehälter aufgefangen. Die Abtrennung der Nanopartikel erfolgte durch Zugabe eines Lösungsmittels (Fällunsmittel/Antisolvent, z.B. Methanol/Propanol Gemisch), welches die reversible Aggregation der Nanopartikel einleitet. Nach der Abtrennung des Überstandes erfolgte eine Redispergierung in Toluol, Chloroform oder einem anderen geeigneten Lösungsmittel. Anschließend kann eine wie auch immer geartet Charakterisierung der Nanoteilchen erfolgen (TEM und UV/VIS - Analyse siehe Figur 4 und 8).

### Beispiel 4: Herstellung von verzweigten CdTe Nanoteilchen

Es wurde eine 0,025 molare Tellur (Te) Lösung (Lösungsmittel Diphyl THT) hergestellt (3,2 g Tellur/l TBP/Diphyl THT Gemisch im Gewichtsverhältnis 1/28). Für die zweite Precursorlösung wurden 0,025 Mol Cadmiumoxid (CdO) pro Liter Ölsäure/Diphyl THT (Gewichtsverhältnis 1/30) Gemisch gelöst. Zur vollständigen Lösung des CdO musste die zweite Precursorlösung auf mindestens 220 °C erwärmt werden. Nach dem Abkühlen der CdO Precursorlösung. konnten beide Precursorlösungen. in einem Vorlagebehälter bei Raumtemperatur oder leicht erhöhter Temperatur vermischt werden. Mit einem Gesamtvolumenstrom von 10 ml/min wurde die Reaktionslösung, bestehend aus beiden zuvor vermischten Precursorlösungen, dann unter Verwendung einer HPLC Doppelkolbenpumpe durch die modulare aufgebaute Mikroreaktionstechnikanlage (Ehrfeld Mikrotechnik BTS GmbH) geführt.

Das Temperiermedium am ersten Mikrowärmetauscher (Gegenstrom Mikrowärmetauscher, V ≈ 0,3 ml, A ≈ 0,0076 m², Ehrfeld Mikrotechnik BTS GmbH) hatte dabei eine Temperatur von 330 °C, während das Temperiermedium für den mikrostrukturierten Reaktor (Sandwichreaktor, V ≈ 30 ml, A ≈ 0,03 m², Ehrfeld Mikrotechnik BTS GmbH) eine Temperatur von 260 °C hatte.

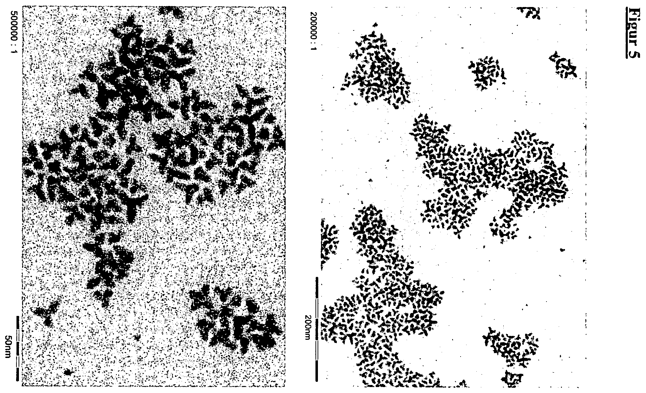

Mithilfe des zweiten Mikrowärmetauschers (Gegenstrom Mikrowärmetauscher oder Rohrtemperiermodul, Ehrfeld Mikrotechnik BTS GmbH) wurde die Reaktionslösung mit den gebildeten Nanopartikeln (erkennbar an der Einfärbung der Reaktionslösung) auf 50 °C abgekühlt und in einem Produktbehälter aufgefangen. Die Abtrennung der Nanopartikel erfolgte durch Zugabe eines Lösungsmittels (Fällunsmittel/Antisolvent, z.B. Methanol/Propanol Gemisch), welches die reversible Aggregation der Nanopartikel einleitet. Nach der Abtrennung des Überstandes erfolgte eine Redispergierung in Toluol, Chloroform oder einem anderen geeigneten Lösungsmittel. Anschließend kann eine wie auch immer geartet Charakterisierung der Nanoteilchen erfolgen (TEM und UV/VIS - Analyse siehe Figur 5 und 9).

### Beispiel 5: Herstellung von ZnSe Nanopartikeln

Es wurde eine 1 molare Selen Lösung (Lösungsmittel Trioctylphosphan) hergestellt (96 g Selen/l TOP) und mit Diphyl THT im Gewichtsverhältnis 2/1 verdünnt. Für die zweite Precursorlösung wurden 0,025 Mol Zinkstearat (ZnSt₂) pro Liter Diphyl THT gelöst. Zur vollständigen Lösung des ZnSt₂ muss die zweite Precursorlösung auf mindestens 200 °C erwärmt werden. Nach dem Abkühlen der ZnSt₂ Precursorlösung konnten beide Precursorlösungen im Gewichtsverhältnis 1/5 in einem Vorlagebehälter bei Raumtemperatur oder leicht erhöhter Temperatur (ca. 100 °C) vermischt werden. Mit einem Gesamtvolumenstrom von 10 ml/min wurde die Reaktionslösung, bestehend aus beiden zuvor vermischten Precursorlösungen, dann unter Verwendung einer HPLC Doppelkolbenpumpe durch die modulare aufgebaute Mikroreaktionstechnikanlage (Ehrfeld Mikrotechnik BTS GmbH) geführt.

Das Temperiermedium am ersten Mikrowärmetauscher (Gegenstrom Mikrowärmetauscher, V ≈ 0,3 ml, A ≈ 0,0076 m², Ehrfeld Mikrotechnik BTS GmbH) hatte dabei eine Temperatur von 330 °C, während das Temperiermedium für den mikrostrukturierten Reaktor (Sandwichreaktor, V ≈ 30 ml, A ≈ 0,03 m², Ehrfeld Mikrotechnik BTS GmbH) eine Temperatur von 300 °C hatte.

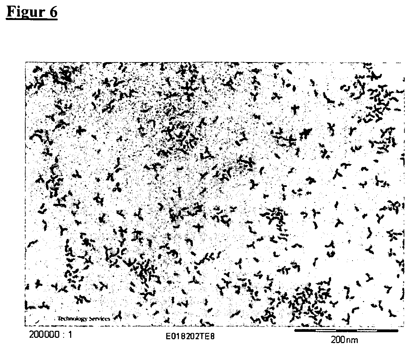

Mithilfe des zweiten Mikrowärmetauschers (Gegenstrom Mikrowärmetauscher oder Rohrtemperiermodul, Ehrfeld Mikrotechnik BTS GmbH) wurde die Reaktionslösung mit den gebildeten Nanopartikeln (erkennbar an der Einfärbung der Reaktionslösung) auf 50 °C abgekühlt und in einem Produktbehälter aufgefangen. Die Abtrennung der Nanopartikel erfolgte durch Zugabe eines Lösungsmittels (Fällunsmittel/Antisolvent, z.B. Methanol/Propanol Gemisch), welches die reversible Aggregation der Nanopartikel einleitet. Nach der Abtrennung des Überstandes erfolgte eine Redispergierung in Toluol, Chloroform oder einem anderen geeigneten Lösungsmittel. Anschließend kann eine wie auch immer geartet Charakterisierung der Nanoteilchen erfolgen (TEM -Analyse siehe Figur 6).

## Patentansprüche

1. Kontinuierliches Flüssigphasen-Verfahren zur Herstellung von metallhaltigen Nanopartikeln und/oder Nanopartikeldispersionen in einem Mikroreaktor, durch folgendene Schritte gekennzeichnet:
a) Injektion bzw. Förderung einer vorgemischten Precursorlösung, die mindestens ein Edukt und mindestens ein Tensid beinhaltet in bzw. durch eine Mikroreaktionstechnikanlage mit durchgesetzten Volumenströme von 0,05 ml/min bis 500 ml/min,
b) Gegebenenfalls Injektion bzw. Förderung einer weiteren Precursorlösung die mindestens ein weiteres Edukt und mindestens ein Tensid beinhaltet, und Vermischung der beiden Precursorlösungen a) und b) über ein geeignetes Mischelement (z.B. Mikromischer) zu einer Reaktionslösung,
c) Initiierung von Keimbildung durch schnelles Aufheizen der aus mindestens 2 Precursorlösungen bestehenden Reaktionslösung auf eine Temperatur bei der Reaktion und Keimbildung in signifikantem Maße stattfinden, von mehr als 200°C,
d) Kontrolliertes Wachstum der Nanopartikel durch Temperieren/Heizen der Reaktionslösung in einem Verweilzeitreaktor auf eine Temperatur von mehr als 150°C, wobei die Temperatur niedriger als die benötigte Temperatur für die Keimbildung sein muss.

2. Verfahren nach Anspruch 1 **dadurch gekennzeichnet, dass** das Verfahren in einer modular aufgebauten Mikroreaktionstechnikanlage durchgeführt wird.

3. Verfahren nach Anspruch 1 oder 2, **dadurch gekennzeichnet, dass** in einem anschließenden Schritt e) das Partikelwachstum durch Abkühlung der Reaktionslösung schlagartig gestoppt wird, wobei die Abkühlungstemperatur niedriger als die Temperatur der Keimbildung und die Wachstumstemperatur ist.

4. Verfahren nach einem der Ansprüche 1 bis 3, **dadurch gekennzeichnet, dass** in einem Mikrowärmetauscher die Temperaturerhöhung für die Keimbildung mit Hilfe eines Verhältnisses von Wärmeübertragungsfläche zu Reaktionsvolumen (A/V Verhältnis) von mindestens 20.000 m²/m³ erreicht wird.

5. Verfahren nach einem der Ansprüche 1 bis 4, **dadurch gekennzeichnet, dass** in dem mikrostrukturierten Reaktor die Temperatur für das Wachstum mit Hilfe eines A/V-Verhältnisses von mindestens 1000 m²/m³ gehalten wird und dessen Verweilzeitverteilung durch den Einsatz statischer Mischeinbauten deutlich enger als in einem Rohr oder in einer Kapillare ist.

6. Verfahren nach einem der Ansprüche 1 bis 5, **dadurch gekennzeichnet, dass** in einem Mikrowärmetauscher im Schritt e) das Partikelwachstum mit einem A/V-Verhältnis von mindestens 20.000 m²/m³ durch abrupte Absenkung der Temperatur gestoppt wird.

7. Verfahren nach einem der Ansprüche 1 bis 6 zur Synthese von Kern-Schale Nanoteilchen, dotierten Nanopartikeln, Nanostäbchen, Nanoplättchen, Nanotetrapods oder mehrfach verzweigten Nanostrukturen, **dadurch gekennzeichnet, dass** in einem beliebig oft wiederholbaren Schritt f) frische Precursorlösung zudosiert und dass das Wachstum wiederholt wird.

## Claims

1. Continuous liquid phase process for preparing metal-containing nanoparticles and/or nanoparticle dispersions in a microreactor, **characterized by** the following steps:
a) injection into or passing through a microreaction technology system of a pre-mixed precursor solution containing at least one reactant and at least one surfactant with volume flow throughputs of from 0.05 ml/min to 500 ml/min,
b) optionally injection or passing of a further precursor solution containing at least one further reactant and at least one surfactant, and mixing of the two precursor solutions a) and b) via a suitable mixing element (e.g. micromixer) to give a reaction solution,
c) initiation of nucleation by heating rapidly the reaction solution consisting of at least 2 precursor solutions to a temperature at which reaction and nucleation take place to a significant extent, to a temperature of more than 200°C,
d) controlled growth of the nanoparticles by thermostatting/heating the reaction solution in a residence time reactor to a temperature of more than 150°C, with the temperature having to be lower than the temperature required for nucleation.

2. Process according to Claim 1, **characterized in that** the process is carried out in a modular microreaction technology system.

3. Process according to Claim 1 or 2, **characterized in that**, in a subsequent step e), particle growth is stopped abruptly by cooling the reaction solution, with the cooling temperature being lower than the nucleation temperature and the growth temperature.

4. Process according to any of Claims 1 to 3, **characterized in that** the temperature increase for nucleation is achieved in a microheat exchanger with the aid of a heat transfer area-to-reaction volume ratio (A/V ratio) of at least 20 000 m²/m³.

5. Process according to any of Claims 1 to 4, **characterized in that** the temperature for growth in the microstructured reactor is maintained with the aid of an A/V ratio of at least 1000 m²/m³ and the residence time distribution thereof is distinctly narrower than in a tube or in a capillary, due to the use of static mixing internals.

6. Process according to any of Claims 1 to 5, **characterized in that**, in step e), particle growth in a microheat exchanger is stopped by abruptly lowering the temperature, with an A/V ratio of at least 20 000 m²/m³.

7. Process according to any of Claims 1 to 6 for the synthesis of core-shell nanoparticles, doped nanoparticles, nanorods, nanoplates, nanotetrapods or polybranched nanostructures, **characterized in that** fresh precursor solution is metered in in a step f) which can be repeated any number of times, and **in that** growth is repeated.

## Revendications

1. Procédé continu en phase liquide pour la préparation de nanoparticules et/ou de dispersions de nanoparticules contenant du métal dans un microréacteur **caractérisé par** les étapes suivantes :
a) injection ou transport d'une solution prémélangée de précurseurs, qui comporte au moins un produit de départ et au moins un tensioactif dans ou par une installation technique de microréaction à un débit volumique de 0,05 ml/min à 500 ml/min,
b) le cas échéant injection ou transport d'une autre solution de précurseurs qui contient au moins un autre produit de départ et au moins un tensioactif et mélange des deux solutions de précurseurs a) et b) par l'intermédiaire d'un élément de mélange approprié (par exemple un micromélangeur) en une solution réactionnelle,
c) initiation d'une formation de germes par le chauffage rapide de la solution réactionnelle constituée par au moins 2 solutions de précurseurs à une température à laquelle la réaction et la formation de germes ont lieu dans une mesure significative, supérieure à 200°C,
d) croissance régulée des nanoparticules par équilibrage thermique/chauffage de la solution réactionnelle dans un réacteur à temps de séjour à une température supérieure à 150°C, la température devant être inférieure à la température nécessaire pour la formation de germes.

2. Procédé selon la revendication 1, **caractérisé en ce que** le procédé est réalisé dans une installation technique de microréaction à construction modulaire.

3. Procédé selon la revendication 1 ou 2, **caractérisé en ce que**, dans une étape e) consécutive, la croissance des particules est arrêtée de manière brusque par refroidissement de la solution réactionnelle, la température de refroidissement étant inférieure à la température de formation de germes et à la température de croissance.

4. Procédé selon l'une quelconque des revendications 1 à 3, **caractérisé en ce que**, dans un microéchangeur de chaleur, l'augmentation de température pour la formation de germes est atteinte à l'aide d'un rapport de la surface de transfert de chaleur au volume de réaction (rapport A/V) d'au moins 20.000 m²/m³.

5. Procédé selon l'une quelconque des revendications 1 à 4, **caractérisé en ce que**, dans le réacteur microstructuré, la température pour la croissance est maintenue à l'aide d'un rapport A/V d'au moins 1000 m²/m³ et sa répartition des temps de séjour est nettement plus étroite que celle dans un tuyau ou dans un capillaire grâce à l'utilisation d'inserts statiques de mélange.

6. Procédé selon l'une quelconque des revendications 1 à 5, **caractérisé en ce que**, dans un microéchangeur de chaleur dans l'étape e), la croissance des particules à un rapport A/V d'au moins 20.000 m²/m³ est arrêtée par un abaissement brusque de la température.

7. Procédé selon l'une quelconque des revendications 1 à 6 pour la synthèse de nanoparticules de type noyau-coquille, de nanoparticules dopées, de nanotiges, de nanoplaquettes, de nanotétrapodes ou de nanostructures à ramifications multiples, **caractérisé en ce que**, dans une étape f) pouvant être répétée aussi souvent que souhaité, de la solution fraîche de précurseurs est ajoutée en dosant et **en ce que** la croissance est répétée.
